# DEMANDE DE BREVET EUROPEEN

(11) **EP 4 560 709 A1**
(43) Date de publication de la demande: **28.05.2025**
(21) Numéro de dépôt: 23211818.2
(22) Date de dépôt: 23.11.2023
(51) Int. Cl.: H01L 31/0468, G04C 10/02

(54) **CELLULE SOLAIRE TRANSPARENTE POUR APPAREIL ÉLECTRONIQUE ET PROCÉDÉ DE FABRICATION DE LADITE CELLULE SOLAIRE**

(71) Demandeur: Nivarox-FAR S.A., 2400 Le Locle (CH)
(72) Inventeur: BAILAT, Julien, 2503 Bienne (CH); CHRISTMANN, Gabriel, 2000 Neuchâtel (CH); DOMINE, Didier, 2515 Prêles (CH)
(74) Mandataire: ICB SA

(57) **Abrégé**

La présente invention concerne une cellule solaire (10) pour appareil électronique comprenant un substrat (100) réalisé dans un matériau transparent destiné à être exposé à un rayonnement lumineux incident, une première électrode (110) réalisée en matériau électriquement conducteur transparent, formée sur une face du substrat (100) et comprenant une face interne (111) opposée à une face externe (112) orientée vers le substrat (100), ladite face interne (111) présentant, sur l'ensemble de sa surface, une rugosité telle qu'elle soit apte à diffuser un rayonnement lumineux incident, une couche absorbante (130) s'étendant par une face externe (131) sur la face interne (111) de la première électrode (110), une seconde électrode (120) réalisée en matériau électriquement conducteur et s'étendant sur une face interne (132) de la couche absorbante (130) opposée à la face externe (131) de cette dernière, la couche absorbante (130) et la seconde électrode (120) étant ajourées de sorte à délimiter une pluralité de cavités (140) borgnes dont le fond de chacune est formé par la face interne (111) de la première électrode (110), la cellule solaire comprenant en outre une couche protectrice (150) transparente recouvrant la seconde électrode (120) et remplissant chaque cavité (140) et présentant un indice de réfraction compris entre 1,3 et 1,8.

## Description

### Domaine technique de l'invention

L'invention relève du domaine des cellules solaires transparentes destinées à alimenter en énergie électrique des appareils électroniques.

Plus particulièrement, l'invention concerne une cellule solaire notamment destinée, dans une application préférée, au domaine de l'horlogerie, c'est-à-dire à alimenter en énergie électrique des moyens moteurs d'un mouvement horloger aptes à piloter des moyens d'affichage d'une pièce d'horlogerie.

De manière plus générale, la cellule solaire selon l'invention est adaptée à s'intégrer dans différents objets transparents, tels que des fenêtres, des hublots ou parebrises, ou dans les écrans d'appareils électroniques portables, tels que les tablettes électroniques, les téléphones portables et les montres électroniques.

### Arrière-plan technologique

Dans certains domaines, notamment dans le domaine du bâtiment, des appareils électroniques portatifs ou de l'horlogerie, il est apparu le besoin de disposer de cellules solaires pouvant se soustraire à la vue d'un utilisateur, afin de constituer une source d'alimentation en énergie électrique tout en permettant à un utilisateur de pouvoir observer à travers ces dernières.

Ce type de cellule solaire est constitué, comme le décrit le document FR2681189, d'une couche absorbante adaptée à absorber la lumière et à la convertir en énergie électrique, généralement réalisée en matériau semi-conducteur tel qu'en silicium, et agencée entre une première électrode réalisée dans un matériau transparent et une seconde électrode réalisée en matériau métallique opaque. La première électrode s'étend sur un substrat transparent formant le support de la cellule solaire.

La couche transparente et la seconde électrode sont ajourées jusqu'au substrat transparent afin d'obtenir une transmission de la lumière nécessaire pour générer la transparence de la cellule solaire.

En particulier, les perforations de la cellule solaire sont dimensionnées et réparties de sorte à permettre à une partie de la lumière incidente de traverser la couche absorbante et la seconde électrode sans être absorbée par ces dernières afin de générer une transparence de la cellule solaire pour un utilisateur la regardant à l'oeil nu.

On comprend naturellement que, plus la surface de la cellule solaire couverte par les perforations est importante, plus la transparence de la cellule solaire est élevée et plus le rendement électrique de la cellule solaire est faible, et à l'inverse, plus cette surface est faible, plus la transparence de la cellule solaire est réduite et son rendement électrique est élevé. En effet, les cellules solaires semi-transparentes laissent passer une partie de la lumière tout en convertissant l'autre partie en électricité grâce à l'effet photovoltaïque.

L'exigence de l'aspect esthétique de la cellule solaire, en particulier sa transparence, se fait donc au détriment de son rendement électrique, de sorte qu'il est nécessaire de respecter un compromis entre le niveau de transparence de la cellule solaire et ses performances électriques.

Afin d'augmenter le rendement électrique de la cellule solaire, la première électrode peut présenter sur une de ses faces une rugosité lui permettant de diffuser la lumière et ainsi d'optimiser son absorption par la couche absorbante par piégeage du rayonnement lumineux incident. Une telle solution est décrite dans le document WO2011/083282.

Cependant, la rugosité de la première électrode génère un certain facteur de diffusion, aussi connu sous le terme « Haze factor » en langue anglaise. Le facteur de diffusion est le rapport de l'intensité de la lumière diffusée par rapport avec celle de la lumière totale transmise. Un facteur de diffusion d'au moins 10% est typiquement souhaité pour optimiser les performances électriques d'une cellule solaire.

Cette solution n'est pas adaptée à une cellule solaire transparente. En effet, un tel facteur de diffusion n'est pas acceptable pour les applications propres à une cellule solaire transparente, notamment l'application horlogère, dans la mesure où ce facteur de diffusion va générer un flou de la cellule solaire troublant la lecture de l'heure et la perception des détails du cadran.

Il apparait donc un besoin d'augmenter le rendement électrique des cellules solaires sans pénaliser leur transparence.

### Résumé de l'invention

L'invention résout les inconvénients précités en proposant une cellule solaire conçue de sorte à présenter un haut niveau de transparence, tout en fournissant des performances électriques élevées, c'est-à-dire en présentant un rendement important.

A cet effet, la présente invention concerne une cellule solaire pour appareil électronique, comprenant un substrat réalisé dans un matériau transparent destiné à être exposé à un rayonnement lumineux incident, et une première électrode réalisée en matériau électriquement conducteur transparent, formée sur une face du substrat et comprenant une face interne opposée à une face externe orientée vers le substrat. La face interne présente, sur l'ensemble de sa surface, une rugosité telle qu'elle soit apte à diffuser un rayonnement lumineux incident, par exemple une rugosité représentée par sa moyenne quadratique Rq comprise entre 5 et 70 nm, voire entre 20 et 70 nm. La cellule solaire comporte en outre une couche absorbante s'étendant par une face externe sur la face interne de la première électrode, et une seconde électrode réalisée en matériau électriquement conducteur et s'étendant sur une face interne de la couche absorbante opposée à la face externe de cette dernière, la couche absorbante et la seconde électrode étant ajourées de sorte à délimiter une pluralité de cavités borgnes dont le fond de chacune est formé par la face interne de la première électrode. La cellule solaire comprend également une couche protectrice transparente recouvrant la seconde électrode et remplissant chaque cavité et présentant un indice de réfraction compris entre 1,3 et 1,8.

Ces caractéristiques permettent de maximiser à la fois la transparence de la cellule solaire et ses performances électriques.

En effet, l'indice de réfraction de la première électrode et celui de la couche protectrice étant très proches, leur interface présente un faible pouvoir réflecteur, ce qui permet de diminuer le facteur de diffusion et ainsi de maximiser la transparence de la cellule.

Par ailleurs, le fait de conserver l'état de surface de la première électrode permet avantageusement d'optimiser le procédé de fabrication de la cellule. En particulier, cette caractéristique permet d'éviter une étape de structuration de la première électrode. Aussi, le fait que ne pas générer d'ouvertures traversantes dans la première électrode permet de conserver des performances électriques optimales, en particulier de faciliter la collecte du courant en minimisant les pertes par résistance série.

Enfin, grâce à l'invention, le pouvoir diffusant est conservé où il est utile pour la cellule solaire, soit en regard de la couche absorbante.

De manière générale, la présente invention trouve une application avantageuse dans tous les domaines dans lesquels l'observation à travers la cellule solaire est un critère important, tel que dans le domaine des vitrages pour les bâtiments, les transports, ou dans le domaine des appareils électroniques, tels que les téléviseurs, les tablettes électroniques ou les téléphones mobiles.

Dans des modes particuliers de réalisation, l'invention peut comporter en outre l'une ou plusieurs des caractéristiques suivantes, prises isolément ou selon toutes les combinaisons techniquement possibles.

Dans des modes particuliers de réalisation, la couche protectrice présente un indice de réfraction compris entre 1,4 et 1,6, par exemple égal à 1,5.

Dans des modes particuliers de réalisation, la couche protectrice est formée par un empilement de deux couches comprenant une première couche déposée contre la première et la seconde électrode, et une seconde couche déposée contre la première couche, la première couche comprenant un indice de réfraction compris entre 1,5 et 1,8 et la seconde couche comprenant un indice de réfraction compris entre 1,3 et 1,5.

Dans des modes particuliers de réalisation, la première couche comprend un indice de réfraction égal à 1,6 ou à 1,7.

Dans des modes particuliers de réalisation, la seconde couche comprenant un indice de réfraction égal à 1,4.

Dans des modes particuliers de réalisation, la couche protectrice est réalisée en parylène, en polyimide, en siloxane, dans un nitrure ou dans un oxyde de silicium.

Dans des modes particuliers de réalisation, le substrat est formé par un empilement de couches comprenant une couche support et une couche intercalaire, cette dernière étant interposée entre la couche support et la première électrode et étant configurée de sorte à présenter un indice de réfraction compris entre 1,6 et 1,9.

Selon un autre objet, la présente invention concerne une pièce d'horlogerie comportant une boîte comprenant une carrure, une glace et un fond définissant un volume interne dans lequel est logé un mouvement horloger. La pièce d'horlogerie comporte en outre une cellule solaire tel que précédemment décrite, agencée pour alimenter en énergie électrique le mouvement horloger.

Dans des modes particuliers de réalisation, la cellule solaire est fixée à la glace de sorte que le substrat soit agencé en appui contre celle-ci, la seconde électrode faisant face au volume interne de la boîte.

Dans des modes particuliers de réalisation, la glace est formée par le substrat, la cellule solaire étant agencée de sorte que la seconde électrode soit en regard du volume interne.

Dans des modes particuliers de réalisation, le substrat constitue le cadran de sorte à faire face à la glace.

La présente invention concerne, selon un autre objet, un procédé de fabrication d'une cellule solaire, comprenant les étapes de :
- formation, sur un substrat transparent, d'une première électrode sous la forme d'une couche transparente conductrice électriquement dotée d'une face interne présentant une rugosité telle qu'elle soit apte à diffuser un rayonnement lumineux incident ;
- formation, sur la face interne de la première électrode, d'une couche absorbante adaptée à absorber un rayonnement lumineux incident et à générer un courant électrique à partir de ce dernier ;
- formation, sur la couche absorbante, d'une seconde électrode sous la forme d'une couche conductrice électriquement ;
- structuration de la seconde électrode et de la couche absorbante de sorte à former une pluralité de cavités borgnes s'étendant jusqu'à la face interne de la première électrode, ladite étape de structuration étant réalisée sans modifier l'état de surface de la face interne ;
- dépôt d'une couche protectrice transparente présentant un indice de réfraction compris entre 1,3 et 1,8, voire entre 1,4 et de 1,6 de sorte à recouvrir la seconde électrode et le fond de chaque cavité.

Dans des modes particuliers de mise en oeuvre, lors de l'étape de structuration, la seconde électrode et la couche absorbante sont ajourées successivement par la mise en oeuvre d'une première et d'une seconde opération de gravure successives.

Dans des modes particuliers de mise en oeuvre, la seconde électrode constitue un masque de gravure lors de la deuxième opération de structuration.

Dans des modes particuliers de mise en oeuvre, l'étape de dépôt d'une couche protectrice comporte une opération de dépôt d'une première couche comprenant un indice de réfraction compris entre 1,5 et 1,8, suivie d'une opération de dépôt d'une seconde couche comprenant un indice de réfraction compris entre 1,3 et 1,5.

Dans des modes particuliers de mise en oeuvre, le substrat est formé, dans une étape préliminaire, par un empilement de couches comprenant une couche support sur laquelle est déposée une couche intercalaire destinée à être interposée entre ladite couche support et la première électrode.

### Brève description des figures

D'autres caractéristiques et avantages de l'invention apparaîtront à la lecture de la description détaillée suivante donnée à titre d'exemple nullement limitatif, en référence aux dessins annexés dans lesquels :
- la figure 1 représente schématiquement une vue de section d'une cellule solaire selon l'invention ;
- les figures 2 à 5 représentent schématiquement une vue de section de la cellule solaire de la figure 1 dans différentes étapes d'un procédé de fabrication selon l'invention ;
- la figure 6 représente schématiquement une vue de section d'une cellule solaire selon un autre exemple de réalisation de l'invention.

On note que les figures ne sont pas nécessairement dessinées à l'échelle pour des raisons de clarté.

### Description détaillée de l'invention

La description de l'invention ci-dessous est réalisée dans le cadre d'une application de l'invention à un appareil électronique formé par une pièce d'horlogerie, par exemple une montre. Toutefois, il va de soi que l'invention n'est pas limitée à cette application et qu'elle pourrait être avantageusement utilisée dans toute autre application.

Par ailleurs, il y a lieu de noter que le terme « transparent » désigne dans le présent texte une capacité d'un matériau à laisser passer tout ou partie d'un rayonnement lumineux, notamment de la lumière visible à l'œil nu.

L'invention concerne une cellule solaire 10 adaptée à transformer un rayonnement lumineux en un courant électrique pour, par exemple, alimenter via un circuit d'alimentation, des moyens moteurs d'un mouvement horloger logé dans une boîte afin de piloter des moyens d'affichage d'une pièce d'horlogerie. Le circuit d'alimentation, les moyens moteurs et les moyens d'affichage d'une pièce d'horlogerie sont bien connus de l'homme du métier et ne concernent pas, en tant que tels, la présente invention, ils ne seront donc pas décrits en détail ci-après et ne sont pas représentés sur les figures.

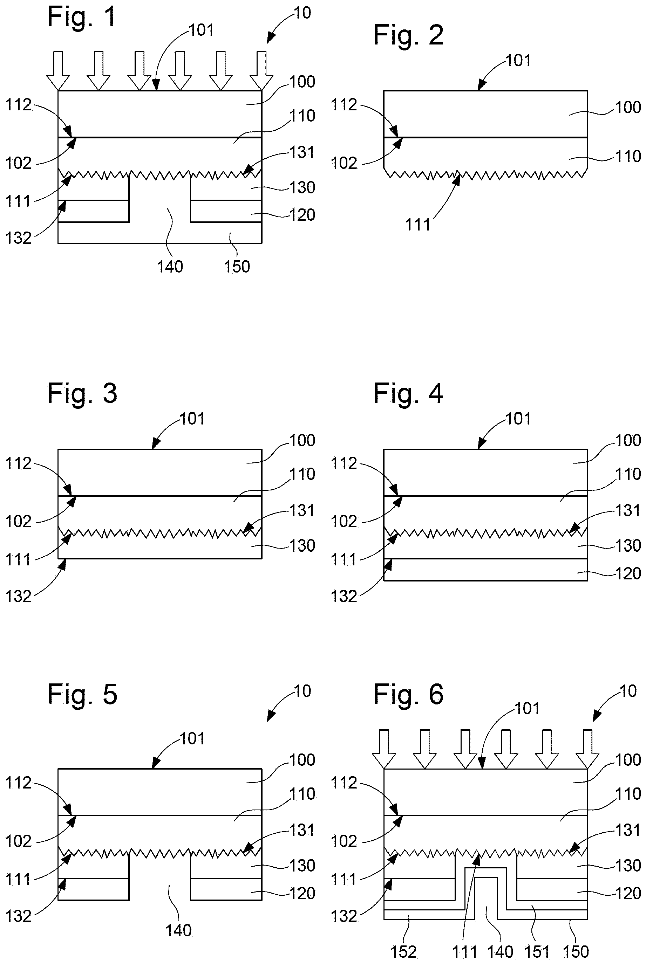

Comme le montre la figure 1, la cellule solaire 10 comporte un substrat 100 réalisé dans un matériau transparent destiné à être exposé à un rayonnement lumineux par une face externe 101. Le substrat 100 est formé par une couche ou par un empilement de couches, tel que décrit plus en détail ci-dessous dans un exemple particulier de réalisation de l'invention. Le substrat 100 présente à titre d'exemple non limitatif une épaisseur comprise entre 0,1 et 2 mm, préférentiellement entre 0,1 et 0,5 mm.

Dans une variante de réalisation, le rayonnement lumineux est un rayonnement incident ou un rayonnement transmis. Sur la figure 1, le rayonnement incident ou le rayonnement transmis est symbolisé par des flèches épaisses.

A titre d'exemple, le substrat 100 peut être fixé de sorte que sa face externe 101 soit agencée contre la glace d'une montre, par exemple par collage ou par des moyens de fixation mécanique ou physique, tel que par liaison ionique ou par liaison par courant d'impulsion, sur sa périphérie. Le rayonnement lumineux auquel est soumis la face externe 101 du substrat 100 est alors un rayonnement transmis à travers la glace.

Alternativement, le substrat 100 peut constituer la glace de la pièce d'horlogerie. Le rayonnement lumineux auquel est soumis la face externe 101 dudit substrat 100 est alors un rayonnement incident. Il est envisageable, en particulier dans ce cas, que le substrat 100 comporte un traitement antireflet sur sa face externe 101 afin de maximiser la quantité de rayonnement lumineux reçu à travers ledit substrat 100.

Dans une autre application de l'invention, le substrat 100 constitue le cadran, de sorte à être agencé en regard de la glace.

Ce substrat 100 est par exemple réalisé en verre, saphir, ou en polymère, tel qu'un polynaphtalate d'éthylène, également connu sous l'acronyme en langue anglaise « PEN », ou un polytéréphtalate d'éthylène, également connu sous l'acronyme en langue anglaise « PET ». D'autres polymères comme le polycarbonate, également connu sous l'acronyme en langue anglaise « PC » ou le poly méthacrylate de méthyle acrylique, également connu sous l'acronyme en langue anglaise « PMMA » sont aussi possibles.

La cellule solaire 10 comporte également une première électrode 110 formée sur tout ou partie d'une surface d'une face interne 102 du substrat 100 opposée à la face externe 101. Cette première électrode 110 est directement exposée à un rayonnement lumineux transmis à travers le substrat 100, issu du rayonnement traversant ledit substrat 100. A titre d'exemple non limitatif, la première électrode 110 présente une épaisseur comprise entre 0,5 et 5 µm, préférentiellement entre 1 et 2 µm.

La première électrode 110 est réalisée en matériau électriquement conducteur transparent, par exemple dans un oxyde métallique, également connu sous l'acronyme en langue anglaise « TCO », tel que l'oxyde de zinc (ZnO), de l'oxyde d'étain (SnO₂) ou de l'oxyde d'indium-étain (ITO), et comprend une face interne 111 opposée à une face externe 112 orientée vers le substrat 100. La face interne 111 présente un état de surface permettant de diffuser le rayonnement lumineux incident.

Plus précisément, la face interne 111 présente, sur l'ensemble de sa surface, une rugosité due à la disposition des cristaux du matériau de la première électrode 110 ; la méthode de dépôt de la première électrode 110 et ses paramètres étant choisis de sorte à contrôler ladite disposition. En d'autres termes, la première électrode 110 est déposée de sorte que ses cristaux définissent un état de surface prédéterminé de sa face interne 111 permettant de diffuser le rayonnement lumineux incident. En particulier, la face interne 111 est configurée de sorte à présenter une rugosité représentée par sa moyenne quadratique Rq comprise entre 5 à 70 nm, voire entre 20 et 70 nm.

La cellule solaire 10 comporte une couche absorbante 130 agencée entre la première électrode 110 et une seconde électrode 120. Comme visible sur la figure 1, la couche absorbante 130 s'étend par une face externe 131 uniquement sur une portion de la face interne 111 de la première électrode 110 et présente par exemple une épaisseur comprise entre 100 nm et 1 µm, et préférentiellement comprise entre 300 et 500 nm.

La couche absorbante 130 est réalisée en matériau semi-conducteur, tel qu'en silicium, par exemple en silicium amorphe. La couche absorbante 130 est adaptée à absorber le rayonnement lumineux et à générer un courant électrique à partir de ce dernier vers des bornes connectées à la première et de la seconde électrode 110 et 120.

Avantageusement et comme représenté schématiquement sur la figure 1, la couche absorbante 130 épouse tout point de la surface de la face interne 111 de la première électrode 110, de sorte qu'elles présentent une forme complémentaire et donc un également une rugosité identique.

La seconde électrode 120 est réalisée en matériau électriquement conducteur et s'étend sur une face interne 132 de la couche absorbante 130 opposée à la face externe 131 de cette dernière.

Avantageusement, la seconde électrode 120 peut être réalisée en TCO, ce qui permet à la couche absorbante 130 de pouvoir absorber une partie du rayonnement transmis à travers le substrat 100 et une partie du rayonnement réfléchi par tout élément disposé dans le voisinage de la cellule solaire 10, à l'opposé dudit substrat 100, c'est-à-dire du côté de la seconde électrode 120. Cette caractéristique permet donc de maximiser la quantité de rayonnement absorbé par la couche absorbante 130 et ainsi, d'augmenter ses performances électriques.

Dans une autre variante de réalisation de l'invention, la seconde électrode 120 est réalisée dans un matériau métallique, tel qu'en argent ou en aluminium.

Tel que visible sur les figures 1 et 5, la couche absorbante 130 et la seconde électrode 120 sont ajourées de sorte à délimiter une pluralité de cavités 140 borgnes dont le fond de chacune est formé par la face interne 111 de la première électrode 110. Autrement dit, la cellule solaire 10 comporte des cavités 140 traversant la seconde électrode 120 et la couche absorbante 130, et s'étendant jusqu'à la face interne 111 de la première électrode 110.

Grâce à ces caractéristiques, le rayonnement lumineux transmis peut traverser la cellule solaire 10 et cette dernière peut présenter un très bon niveau de transparence, selon le motif de répartition des cavités 140 et leurs dimensions.

Avantageusement, les cavités 140 peuvent présenter une section droite de forme circulaire ou hexagonale. Cette dernière forme a pour avantage de minimiser la perte électrique.

Les sections droites des cavités 140 peuvent alternativement présenter toutes sortes de formes régulières ou irrégulières, géométriquement simples ou multiples assurant un pavage débouchant sur la face interne 111 de la première électrode 110. A titre d'exemples, les cavités 140 peuvent être filiformes, telles que des saignées, ou de forme polygonales, telles que triangulaires, carrées, de la forme de lettres, de logos, etc.

Comme illustrée sur la figure 1, la cellule solaire 10 comporte avantageusement une couche protectrice 150 réalisée dans un matériau transparent, encapsulant la première et la seconde électrode 110 et 120, ainsi que la couche absorbante 130 ; c'est-à-dire qu'elle remplit chaque cavité 140. Cette couche protectrice 150 est donc déposée sur un coté de la cellule solaire 10 opposé au substrat 100, et permet de protéger la cellule solaire 10 de toute agression ou pollution extérieure.

Une telle couche protectrice 150 peut être réalisée en parylène, en polyimide, en siloxane, dans un nitrure, par exemple en nitrure de silicium, ou dans un oxyde, par exemple en oxyde de silicium.

Cette couche présente une fonction optique avantageuse. En particulier, le matériau de la couche protectrice 150 est choisi de sorte qu'elle présente un indice de réfraction compris entre celui de l'air ambiant, qui est environ égal à 1, et celui de la première électrode 110, qui est environ égal à 2. Ceci de sorte à minimiser le facteur de diffusion à l'interface entre la face interne 111 de la première électrode 110 et la couche protectrice 150, et de sorte à minimiser le pouvoir réflecteur à l'interface entre l'air et la couche protectrice 150. En particulier, la couche protectrice 150 est configurée de sorte que son indice de réfraction soit compris entre 1,3 et 1,8, voire entre 1,4 et 1,6, et préférentiellement égal à 1,5.

Cette caractéristique permet d'augmenter la transparence de la cellule solaire 10 au niveau des cavités 140. En effet, les indices de réfraction de la face interne 111 de la première électrode 110 et de la couche protectrice 150 étant proches l'un de l'autre, le rayonnement lumineux est très peu diffusé par la face interne 111 de la première électrode 110. En outre, l'indice de réfraction de la couche protectrice 150 étant également proche de celui de l'air, le rayonnement lumineux passant à travers la cellule solaire 10 est peu réfléchi. En particulier, l'interface entre la face interne 110 la première électrode 110 et la couche protectrice 150 transmet une très grande partie du rayonnement lumineux, par exemple plus de 98%.

A titre d'exemple, si la face interne 111 de la première électrode 110 présente une rugosité Rq égale à 60 nm et que la couche protectrice 150 présente un indice de réfraction de 1,5, le facteur de diffusion de la première électrode 110 est compris entre 4 et 5%, alors que si la face interne 111 présente une interface avec l'air, son facteur de diffusion est de 35%. En outre, si la couche protectrice 150 présente un indice de réfraction de 1,7, le facteur de diffusion de la première électrode 110 est de 1%.

Grâce à la présente invention, la cellule solaire 10 présente donc une grande transparence, ce qui permet à un utilisateur de pouvoir clairement voir à travers. Cette transparence est obtenue en conservant l'état de surface de la face interne 111 de la première électrode 110, et donc en évitant la réalisation d'une éventuelle opération de structuration au niveau du fond des cavités 140. A titre informatif, une telle opération de structuration aurait permis d'éliminer une partie de la première électrode 110 ou de lisser son état de surface.

Dans un exemple de réalisation de l'invention représenté sur la figure 6, la couche protectrice 150 est formée par un empilement de deux couches comprenant une première couche 151 déposée contre la première et la seconde électrode 110 et 120, et une seconde couche 152 déposée contre la première couche 151.

La première couche 151 comprend avantageusement un indice de réfraction compris entre 1,5 et 1,8 et préférentiellement égal à 1,6 ou 1,7. La seconde couche 152 comprend un indice de réfraction compris entre 1,3 et 1,5 et préférentiellement égal à 1,4. Ainsi, la différence entre les indices de réfraction de la première électrode 110 et de la première couche 151 est minimisée, de même que la différence entre les indices de réfraction de cette dernière et la seconde couche 152, et que la différence entre les indices de réfraction de la seconde couche 152 et de l'air. Minimiser la différence entre deux milieux contigus permet, tel que décrit précédemment, d'améliorer considérablement la transparence de la cellule solaire 10.

Dans un exemple de réalisation de l'invention non représenté sur les figures, le substrat 100 est formé par un empilement de couches comprenant une couche support et une couche intercalaire, cette dernière étant interposée entre la couche support et la première électrode 110 et étant configurée de sorte à présenter un indice de réfraction tel qu'elle minimise les réflexions optiques et ainsi favorise la transparence de la cellule solaire 10. En particulier, la couche intercalaire s'étend par exemple sur une épaisseur comprise entre 60 et 100 nm et présente un indice de réfraction compris entre 1,6 et 1,9. Cette couche intercalaire peut être réalisée en tout matériau transparent approprié.

La couche support peut être réalisée en tout matériau transparent, par exemple dans un matériau tel que mentionné ci-dessus pour le substrat 100.

La présente invention concerne également un procédé de fabrication d'une cellule solaire 10, préférentiellement conforme à la cellule solaire 10 décrite précédemment.

Le procédé de fabrication comprend les étapes successives suivantes, représentées chronologiquement respectivement par les figures 2 à 5 et 1.

Ce procédé comporte avantageusement une étape de formation de la première électrode 110 sur le substrat 100, de sorte que ladite première électrode 110 comporte, sur l'ensemble de sa face interne 111, une rugosité telle qu'elle soit apte à diffuser un rayonnement lumineux incident, par exemple une rugosité Rq comprise entre 5 et 70 nm, voire entre 20 et 70 nm.

Cette étape est suivie d'une étape de formation de la couche absorbante 130 sur la face interne 111 de la première électrode 110, puis d'une étape de formation de la seconde électrode 120 sur la couche absorbante 130.

Une étape de structuration est ensuite réalisée afin de former une pluralité de cavités 140 borgnes à travers la seconde électrode 120 et de la couche absorbante 130, jusqu'à la face interne 111 de la première électrode 110.

La détermination des zones à ajourer lors de l'étape de structuration est réalisée en masquant les zones de la seconde électrode 120 et de la couche absorbante 130 à préserver, par exemple par photolithographie.

Lors de l'étape de structuration, la seconde électrode 120 et la couche absorbante 130 peuvent être ajourées successivement par la mise en oeuvre d'opérations de gravures successives. En particulier, une première opération de gravure peut consister à former une pluralité de cavités 140 à travers la seconde électrode 120 et s'étendant jusqu'à la couche absorbante 130, et une seconde opération de gravure peut être menée de sorte à étendre les cavités 140 à travers la couche absorbante 130, jusqu'à la première électrode 110.

Compte-tenu des matériaux constituant respectivement la seconde électrode 120 et la couche absorbante 130, la première opération de gravure peut être réalisée par la mise en oeuvre d'une méthode de gravure chimique humide, et la seconde opération de gravure peut être réalisée par la mise en oeuvre d'une méthode de gravure sèche, telle qu'une méthode de gravure chimique par plasma ou de gravure ionique.

Avantageusement, la seconde électrode 120 peut servir de masque de gravure lors de la seconde opération de structuration et ainsi protéger la portion de couche absorbante 130 sur laquelle elle est déposée.

Le fait de ne pas ajourer la première électrode 110 permet de ne pas augmenter sa résistance électrique, la performance électrique de la cellule solaire 10 est ainsi préservée. Aussi, cela permet de réduire le temps de réalisation du procédé et l'énergie consommée pour sa mise en oeuvre.

Une étape de dépôt d'une couche protectrice 150 transparente est ensuite mise en oeuvre à la suite de l'étape de structuration de sorte à recouvrir la seconde électrode 120 et le fond de chaque cavité 140.

Notamment, cette étape peut être réalisée par enduction centrifuge, aussi connue sous la dénomination « spin coating » en langue anglaise, par exemple si le matériau de la couche protectrice 150 est en polyimide. Cette étape peut alternativement être réalisée par une méthode de dépôt chimique en phase vapeur, si le matériau de la couche protectrice 150 est en parylène, ou par une méthode de dépôt chimique en phase vapeur assisté par plasma, si le matériau choisi pour former la couche protectrice 150 est un oxyde ou un nitrure. Il est également envisageable de déposer la couche protectrice 150 par une méthode de dépôt physique en phase vapeur, par évaporation ou par pulvérisation cathodique, par exemple dans le cas où la couche protectrice 150 est en nitrure.

Alternativement, la couche protectrice 150 peut être formé par un film autocollant transparent collé, lors de l'étape de dépôt, contre la première et la seconde électrode 110 et 120.

Le substrat 100 peut être formé, dans une étape préliminaire, par un empilement de couches comprenant une couche support sur laquelle est déposée une couche intercalaire, la première électrode 110 étant déposée sur cette dernière.

La formation d'une première électrode 110 peut être réalisée par la mise en oeuvre d'une méthode de dépôt chimique en phase vapeur, la formation de la couche absorbante 130 peut être réalisée par la mise en oeuvre de dépôt chimique en phase vapeur assisté par plasma et la formation de la seconde électrode 120 peut être réalisée par la mise en oeuvre d'une méthode de dépôt physique en phase vapeur.

Bien entendu, ces méthodes de dépôt sont données à titre indicatif, la première et la seconde électrode 110 et 120 ainsi que la couche absorbante 130 pouvant être déposés par toute méthode de dépôt adaptée selon leur matériau respectif.

De manière plus générale, il est à noter que les modes de mise en oeuvre et de réalisation considérés ci-dessus ont été décrits à titre d'exemples non limitatifs, et que d'autres variantes sont par conséquent envisageables.

Notamment, la première et la seconde électrode 110 et 120, ainsi que la couche absorbante 130 et la couche protectrice 150 peuvent être formées par une unique couche ou par un empilement de couches.

## Revendications

1. Cellule solaire (10) pour appareil électronique **caractérisée en ce qu'**elle comprend un substrat (100) réalisé dans un matériau transparent destiné à être exposé à un rayonnement lumineux incident, une première électrode (110) réalisée en matériau électriquement conducteur transparent, formée sur une face du substrat (100) et comprenant une face interne (111) opposée à une face externe (112) orientée vers le substrat (100), ladite face interne (111) présentant, sur l'ensemble de sa surface, une rugosité telle qu'elle soit apte à diffuser un rayonnement lumineux incident, une couche absorbante (130) s'étendant par une face externe (131) sur la face interne (111) de la première électrode (110), une seconde électrode (120) réalisée en matériau électriquement conducteur et s'étendant sur une face interne (132) de la couche absorbante (130) opposée à la face externe (131) de cette dernière, la couche absorbante (130) et la seconde électrode (120) étant ajourées de sorte à délimiter une pluralité de cavités (140) borgnes dont le fond de chacune est formé par la face interne (111) de la première électrode (110), la cellule solaire comprenant en outre une couche protectrice (150) transparente recouvrant la seconde électrode (120) et remplissant chaque cavité (140) et présentant un indice de réfraction compris entre 1,3 et 1,8.

2. Cellule solaire (10) selon la revendication 1, dans laquelle la couche protectrice (150) présente un indice de réfraction égal à 1,5.

3. Cellule solaire (10) selon la revendication 1 ou 2, dans laquelle la couche protectrice (150) est formée par un empilement de deux couches comprenant une première couche (151) déposée contre la première et la seconde électrode (110, 120), et une seconde couche (152) déposée contre la première couche (151), la première couche (151) comprenant un indice de réfraction compris entre 1,5 et 1,8 et la seconde couche (152) comprenant un indice de réfraction compris entre 1,3 et 1,5.

4. Cellule solaire (10) selon la revendication 3, dans laquelle la première couche (151) comprend un indice de réfraction égal à 1,6 ou à 1,7.

5. Cellule solaire (10) selon la revendication 3 ou 4, dans laquelle la seconde couche (152) comprenant un indice de réfraction égal à 1,4.

6. Cellule solaire (10) selon l'une des revendications 1 à 5, dans laquelle la couche protectrice (150) est réalisée en parylène, en polyimide, en siloxane, dans un nitrure ou dans un oxyde.

7. Cellule solaire (10) selon l'une des revendications 1 à 6, dans laquelle le substrat (100) est formé par un empilement de couches comprenant une couche support et une couche intercalaire, cette dernière étant interposée entre la couche support et la première électrode (110) et étant configurée de sorte à présenter un indice de réfraction compris entre 1,6 et 1,9.

8. Pièce d'horlogerie comportant une boîte comprenant une carrure, une glace et un fond définissant un volume interne dans lequel est logé un mouvement horloger, ladite pièce d'horlogerie étant **caractérisée en ce qu'**elle comporte en outre une cellule solaire (10) selon l'une des revendications 1 à 7 agencée pour alimenter en énergie électrique le mouvement horloger.

9. Pièce d'horlogerie selon la revendication 8, dans laquelle la cellule solaire (10) est fixée à la glace de sorte que le substrat (100) soit agencé en appui contre celle-ci, la couche protectrice (150) faisant face au volume interne de la boîte.

10. Pièce d'horlogerie selon la revendication 8, dans laquelle la glace est formée par le substrat (100), la cellule solaire (10) étant agencée de sorte que la couche protectrice (150) soit en regard du volume interne.

11. Pièce d'horlogerie selon la revendication 8, dans laquelle le substrat (100) constitue le cadran de sorte à faire face à la glace.

12. Procédé de fabrication d'une cellule solaire (10), **caractérisé en ce qu'**il comprend les étapes de :
- formation, sur un substrat (100) transparent, d'une première électrode (110) sous la forme d'une couche transparente conductrice électriquement dotée d'une face interne présentant une rugosité telle qu'elle soit apte à diffuser un rayonnement lumineux incident ;
- formation, sur la face interne (111) de la première électrode (110), d'une couche absorbante (130) adaptée à absorber un rayonnement lumineux incident et à générer un courant électrique à partir de ce dernier ;
- formation, sur la couche absorbante (130), d'une seconde électrode (120) sous la forme d'une couche conductrice électriquement ;
- structuration de la seconde électrode (120) et de la couche absorbante (130) de sorte à former une pluralité de cavités (140) borgnes s'étendant jusqu'à la face interne (111) de la première électrode (110), ladite étape de structuration étant réalisée sans modifier l'état de surface de la face interne (111) ;
- dépôt d'une couche protectrice (150) transparente présentant un indice de réfraction compris entre 1,3 et 1,8, de sorte à recouvrir la seconde électrode (120) et le fond de chaque cavité (140).

13. Procédé de fabrication d'une cellule solaire (10) selon la revendication 12, dans lequel, lors de l'étape de structuration, la seconde électrode (120) et la couche absorbante (130) sont ajourées successivement par la mise en oeuvre d'une première et d'une seconde opération de gravure successives.

14. Procédé de fabrication d'une cellule solaire (10) selon la revendication 12, dans lequel la seconde électrode (120) constitue un masque de gravure lors de la deuxième opération de structuration.

15. Procédé de fabrication d'une cellule solaire (10) selon l'une des revendications 12 à 14, dans lequel l'étape de dépôt d'une couche protectrice (150) comporte une opération de dépôt d'une première couche (151) comprenant un indice de réfraction compris entre 1,5 et 1,8, suivie d'une opération de dépôt d'une seconde couche (152) comprenant un indice de réfraction compris entre 1,3 et 1,5.

16. Procédé de fabrication d'une cellule solaire (10) selon l'une des revendications 12 à 15, dans lequel le substrat (100) est formé, dans une étape préliminaire, par un empilement de couches comprenant une couche support sur laquelle est déposée une couche intercalaire destinée à être interposée entre ladite couche support et la première électrode (110).
